# EUROPÄISCHE PATENTSCHRIFT

(11) **EP 2 591 502 B1**
(45) Veröffentlichungstag und Bekanntmachung des Hinweises auf die Patenterteilung: **11.10.2017**
(21) Anmeldenummer: 11726076.0
(22) Anmeldetag: 24.05.2011
(51) Int. Cl.: H01L 25/075, H01L 33/62, H01L 33/64, H01L 33/54, H05K 1/02, H01L 33/60, H05K 1/05

(54) **LEUCHTDIODE**
LIGHT-EMITTING DIODE
DIODE ÉLECTROLUMINESCENTE

(30) Priorität: 07.07.2010 DE 102010026344
(43) Veröffentlichungstag der Anmeldung: 15.05.2013
(73) Patentinhaber: OSRAM Opto Semiconductors GmbH, 93055 Regensburg (DE)
(72) Erfinder: REILL, Joachim, 93197 Zeitlarn (DE); BOGNER, Georg, 93138 Lappersdorf (DE); GRÖTSCH, Stefan, 93077 Lengfeld - Bad Abbach (DE)
(74) Vertreter: Epping - Hermann - Fischer
(86) Internationale Anmeldenummer: PCT/EP2011/058494
(87) Internationale Veröffentlichungsnummer: WO 2012/004049

(56) Entgegenhaltungen:
- EP-A1- 2 216 834
- EP-A2- 1 843 394
- WO-A1-2004/068596
- WO-A1-2006/089512
- WO-A1-2009/138374
- WO-A2-2005/008791
- WO-A2-2009/075530
- DE-C1- 10 245 946
- US-A1- 2003 189 830
- US-A1- 2008 231 169
- US-A1- 2009 278 139
- US-A1- 2010 140 648

## Beschreibung

Es wird eine Leuchtdiode angegeben.

Die Druckschrift WO 2006/012842 beschreibt ein Leuchtmodul.

Die Druckschriften US 2003/0189830, WO 2005/008791, WO 2004/068596, US 2009/0278139, EP 1843394 und US 2010/0140648 offenbaren jeweils LED-Chips, die auf einem metallischen Träger angeordnet sind. In den Druckschriften WO 2009/075530 und EP 2 216 834 sind Umhüllungen mit reflektierenden Partikeln beschrieben, wobei Leuchtdioden zumindest teilweise von den Umhüllungen umschlossen sind.

Bei der Verwendung von Leuchtdioden in Kfz-Scheinwerfern ist die Abfuhr der von den Leuchtdioden im Betrieb erzeugten Wärme oft problematisch.

Eine zu lösende Aufgabe besteht darin, eine Leuchtdiode anzugeben, die sich beispielsweise für den Einsatz in einem Kfz-Scheinwerfer besonders gut eignet.

Gemäß zumindest einer Ausführungsform der Leuchtdiode umfasst die Leuchtdiode einen Träger. Der Träger ist beispielsweise nach Art einer Platte ausgebildet. Das heißt, die laterale Erstreckung des Trägers ist groß im Vergleich mit seiner Dicke. Der Träger weist eine Montagefläche auf, die zur Aufnahme von Komponenten der Leuchtdiode vorgesehen ist.

Gemäß der erfindungsgemäßen Ausführungsform der Leuchtdiode umfasst die Leuchtdiode zumindest zwei Leuchtdiodenchips. Die Leuchtdiode umfasst vorzugsweise eine Vielzahl von Leuchtdiodenchips, beispielweise vier oder mehr Leuchtdiodenchips. Die Leuchtdiodenchips der Leuchtdiode sind dazu vorgesehen, im Betrieb elektromagnetische Strahlung im Frequenzbereich von Infrarotstrahlung bis UV-Strahlung zu erzeugen. Die Leuchtdiodenchips stellen dabei die Lichtquellen der Leuchtdiode dar. Vorzugsweise strahlt die Leuchtdiode selbst weißes Licht ab.

Gemäß der erfindungsgemäßen Ausführungsform der Leuchtdiode sind die zumindest zwei Leuchtdiodenchips, vorzugsweise alle Leuchtdiodenchips der Leuchtdiode, zumindest mittelbar an der Montagefläche am Träger befestigt. Zumindest mittelbar heißt, dass sich zwischen den Leuchtdiodenchips und der Montagefläche weiteres Material wie beispielsweise ein Zwischenträger oder ein Verbindungsmittel - etwa ein Klebstoff oder ein Lot - befinden kann.

Gemäß der erfindungsgemäßen Ausführungsform der Leuchtdiode weist der Träger einen metallischen Grundkörper auf. Vorzugsweise bildet der metallische Grundkörper dann den Hauptbestandteil des Trägers. Beispielsweise entfallen auf den metallischen Grundkörper wenigstens 90 % des Volumens und wenigstens 90 % des Gewichts des Trägers. Der metallische Grundkörper ist beispielsweise mit einem gut strom- und wärmeleitenden Metall, wie etwa Kupfer gebildet.

Der metallische Grundkörper umfasst eine Außenfläche, welche die Montagefläche des Trägers umfasst. Das heißt, zumindest Stellen der Außenfläche des metallischen Grundkörpers des Trägers bilden die Montagefläche, an der die zumindest zwei Leuchtdiodenchips zumindest mittelbar am Träger befestigt sind.

Gemäß der erfindungsgemäßen Ausführungsform der Leuchtdiode sind die zumindest zwei Leuchtdiodenchips, vorzugsweise alle Leuchtdiodenchips der Leuchtdiode, zueinander elektrisch parallel geschaltet.

Gemäß der erfindungsgemäßen Ausführungsform der Leuchtdiode umfasst die Leuchtdiode einen Träger mit einer Montagefläche und zumindest zwei Leuchtdiodenchips, die zumindest mittelbar an der Montagefläche am Träger befestigt sind. Der Träger umfasst dabei einen metallischen Grundkörper, der eine Außenfläche aufweist, welche die Montagefläche des Trägers umfasst. Die zumindest zwei Leuchtdiodenchips der Leuchtdiode sind dabei zueinander parallel geschaltet.

Der hier beschriebenen Leuchtdiode liegt dabei unter anderem die Idee zugrunde, dass die Anordnung der Leuchtdiodenchips der Leuchtdiode möglichst nahe an einem metallischen Grundkörper eine besonders effiziente Wärmespreizung der von den Leuchtdiodenchips im Betrieb der Leuchtdioden erzeugten Wärme erlaubt. Das heißt, die von den Leuchtdiodenchips erzeugte Wärme wird möglichst bald nach ihrer Erzeugung über das gesamte Volumen des metallischen Grundkörpers verteilt, der einen Hauptbestandteil des Trägers bildet.

Gemäß zumindest einer Ausführungsform der Leuchtdiode umfasst die Leuchtdiode zumindest eine Öffnung im Träger. Die Öffnung erstreckt sich dabei von einer Oberseite des Trägers zu einer der Oberseite abgewandten Unterseite des Trägers. Beispielsweise erstreckt sich die Öffnung von einer Deckfläche des Trägers zu einer Bodenfläche des Trägers. Die Öffnung durchdringt den Träger dabei vorzugsweise vollständig. Die Öffnung kann zum Beispiel als Bohrung im Träger ausgeführt sein oder die Öffnung wird bereits bei der Herstellung des Trägers vorgesehen. Die Öffnung weist eine Innenfläche auf, in der das Material des Trägers an die Öffnung grenzt. Die Innenfläche ist dabei mit einem elektrisch isolierenden Material bedeckt. Beispielsweise ist die gesamte Innenfläche der Öffnung mit dem elektrisch isolierenden Material beschichtet, so dass innerhalb der Öffnung an keiner Stelle Material des Trägers freiliegt.

Die Öffnung dient zum Beispiel zur Aufnahme eines Befestigungsmittels zur Montage der Leuchtdiode. Beispielsweise kann es sich bei dem Befestigungsmittel um eine Schraube oder einen Passstift zur Presspassung handeln.

Bei dem elektrisch isolierenden Material, mit dem die Innenfläche der Öffnung bedeckt ist, handelt es sich beispielsweise um einen elektrisch isolierenden Kunststoff oder um eine Schicht, die mit einem elektrisch isolierenden Material wie Siliziumdioxid oder Siliziumnitrid gebildet ist. Ferner kann das elektrisch isolierende Material keramisch sein. Das elektrisch isolierende Material kann zum Beispiel ein Bornitrid enthalten oder aus einem Bornitrid bestehen. Das elektrisch isolierende Material kann als Schicht die Seitenfläche oder die Seitenflächen der Öffnung vollständig bedecken. Das elektrisch isolierende Material kann zum Beispiel mit einer Dicke zwischen wenigstens 30 µm und höchstens 100 µm aufgebracht sein.

Die Leuchtdiode kann im Träger mehrere Öffnungen, zum Beispiel zwei oder mehr Öffnungen umfassen. Jede der Öffnungen ist dann in der beschriebenen Weise ausgestaltet und dient zur Aufnahme eines Befestigungsmittels zur Montage der Leuchtdiode am vorgesehenen Einsatzort.

Gemäß zumindest einer Ausführungsform durchdringt die Öffnung den metallischen Grundkörper vollständig. Das heißt, die zumindest eine Öffnung ist im Bereich des metallischen Grundkörpers im Träger ausgebildet. Zumindest im Bereich des metallischen Grundkörpers ist die Innenfläche der Öffnung dann vorzugsweise mit dem elektrisch isolierenden Material vollständig bedeckt. Das heißt, der metallische Grundkörper liegt an keiner Stelle der Öffnung frei und kann somit im Betrieb der Leuchtdiode auf einfache Weise potenzial freigehalten werden.

Gemäß zumindest einer Ausführungsform der Leuchtdiode ist die Montagefläche des Trägers an der Oberseite des Trägers angeordnet und die Leuchtdiodenchips sind direkt an der Montagefläche am Träger befestigt. Beispielsweise sind die Leuchtdiodenchips in diesem Fall an der Montagefläche auf den Träger aufgelötet. Mit anderen Worten, sind die Leuchtdiodenchips direkt auf den metallischen Grundkörper des Trägers aufgebracht und stehen mit diesem abgesehen von einem Verbindungsmittel, wie beispielsweise dem Lot, in direktem Kontakt. An der Unterseite des Trägers, das heißt an der der Montagefläche abgewandten Seite des Trägers ist dann erfindungsgemäß eine elektrisch isolierende Schicht am Träger befestigt. Die elektrisch isolierende Schicht befindet sich vorzugsweise in direktem Kontakt mit dem metallischen Grundkörper. Die elektrisch isolierende Schicht bedeckt den Träger an seiner Unterseite - abgesehen von den Öffnungen - vorzugsweise vollständig. Das heißt, auch der metallische Grundkörper ist an seiner der Montagefläche abgewandten Seite dann vollständig von der elektrisch isolierenden Schicht bedeckt. Die elektrisch isolierende Schicht weist dabei eine erfindungsgemäße Wärmeleitfähigkeit von zumindest 2 W/(mK) auf.

Mit anderen Worten sind in diesem Ausführungsbeispiel die Leuchtdiodenchips direkt auf den metallischen Grundkörper montiert, was eine optimale thermische Ankopplung der Leuchtdiodenchips an den Träger erlaubt. Der gesamte metallische Grundkörper des Trägers dient als Element zur Wärmespreizung. Die Leuchtdiodenchips können in diesem Fall elektrisch leitend mit dem metallischen Grundkörper verbunden sein und über den metallischen Grundkörper parallel zueinander geschaltet sein. Die elektrische Isolation des metallischen Grundkörpers wird an der der Montagefläche abgewandten Seite mittels der elektrisch isolierenden Schicht, die sich durch eine besonders hohe Wärmeleitfähigkeit auszeichnet, realisiert. Dieser Aufbau der Leuchtdiode ermöglicht eine frühe Wärmespreizung direkt an der Wärmequelle, also den Leuchtdiodenchips, und dadurch einen besonders niedrigen Wärmewiderstand der gesamten Leuchtdiode.

Gemäß zumindest einer Ausführungsform der Leuchtdiode ist die elektrisch isolierende Schicht eine keramische Schicht. Das heißt die elektrisch isolierende Schicht weist keramische Eigenschaften auf. Die elektrisch isolierende Schicht kann dann ein keramischen Material enthalten oder aus einem keramischen Material bestehen. Die elektrisch isolierende Schicht weist dabei eine Wärmeleitfähigkeit von zumindest 2 W/ (mK) auf.

Gemäß zumindest einer Ausführungsform der Leuchtdiode weist die elektrisch isolierende Schicht eine Dicke von wenigstens 30 µm und höchstens 100 µm auf. Zum Beispiel weist die elektrisch isolierende Schicht eine Dicke zwischen wenigstens 50 µm und höchstens 70 µm auf.

Gemäß zumindest einer Ausführungsform der Leuchtdiode enthält die elektrisch isolierende Schicht Bornitrid oder besteht aus Bornitrid. Die elektrisch isolierende Schicht kann dabei eine Dicke von wenigstens 30 µm und höchstens 100 µm, zum Beispiel zwischen wenigstens 50 µm und höchstens 70 µm aufweisen. Die elektrisch isolierende Schicht weist dabei eine Wärmeleitfähigkeit von zumindest 2 W/(mK) auf.

Gemäß der erfindungsgemäßen Ausführungsform der Leuchtdiode sind die Leuchtdiodenchips elektrisch leitend mit dem metallischen Grundkörper verbunden und über den metallischen Grundkörper parallel zueinander geschaltet. Das heißt, die Leuchtdiodenchips befinden sich dann an ihrer dem metallischen Grundkörper zugewandten Seite auf demselben elektrischen Potenzial wie der metallische Grundkörper.

Gemäß zumindest einer Ausführungsform der Leuchtdiode durchdringt die Öffnung die elektrisch isolierende Schicht an der Unterseite des Trägers vollständig. Das heißt, auch die elektrisch isolierende Schicht ist von der Öffnung durchbrochen. Die Öffnung kann dabei vor oder nach dem Aufbringen der elektrisch isolierenden Schicht auf dem metallischen Grundkörper erzeugt werden. Eine Seitenfläche der elektrisch isolierenden Schicht in der Öffnung ist vorzugsweise mit dem elektrisch isolierenden Material bedeckt, mit dem die Innenfläche auch im Bereich des metallischen Grundkörpers bedeckt ist. Beispielsweise wird die Innenfläche der Öffnung dazu erst nach dem Aufbringen der elektrisch isolierenden Schicht an der Unterseite des Trägers mit dem elektrisch isolierenden Material beschichtet. Dabei ist es auch möglich, dass die elektrisch isolierende Schicht an der Unterseite des Trägers mit dem gleichen Material, das heißt dem elektrisch isolierenden Material gebildet ist. Gemäß zumindest einer Ausführungsform der Leuchtdiode ist zwischen den Leuchtdiodenchips und der Montagefläche ein Zwischenträger angeordnet, an dem die Leuchtdiodenchips befestigt sind. Der Zwischenträger kann ein keramisches Material umfassen oder aus einem keramischen Material bestehen. Das heißt, der Zwischenträger stellt dann eine elektrische Isolation der Leuchtdiodenchips zum Träger und damit insbesondere zum metallischen Grundkörper dar. In diesem Fall kann die elektrisch isolierende Schicht an der Unterseite des Trägers auch entfallen.

Gemäß zumindest einer Ausführungsform der Leuchtdiode umfasst der Träger eine weitere elektrische isolierende Schicht, die an der den Leuchtdiodenchips zugewandten Seite am metallischen Grundkörper befestigt ist. Auf der dem metallischen Grundkörper abgewandten Seite der weiteren elektrisch isolierenden Schicht ist dann eine elektrisch leitende Schicht angeordnet, an welche die Leuchtdiodenchips elektrisch leitend angeschlossen sind. Die elektrisch leitende Schicht kann dabei zu Leiterbahnen strukturiert sein, welche die Leuchtdiodenchips der Leuchtdiode kontaktieren.

Gemäß zumindest einer Ausführungsform der Leuchtdiode durchdringt die Öffnung die weitere elektrisch isolierende Schicht und die elektrisch leitende Schicht vollständig. Dabei sind Seitenflächen der weiteren elektrisch isolierenden Schicht und der elektrisch leitenden Schicht in der Öffnung mit dem elektrisch isolierenden Material bedeckt. Das heißt, in diesem Ausführungsbeispiel ist vorzugsweise die gesamte Innenfläche der Öffnung vom elektrisch isolierenden Material bedeckt. Abgesehen vom metallischen Grundkörper sind auch die weitere elektrisch isolierende Schicht und die elektrisch leitende Schicht vom elektrisch isolierenden Material bedeckt und somit zum Befestigungsmittel in der Öffnung hin elektrisch isoliert.

Gemäß der erfindungsgemäßen Ausführungsform der Leuchtdiode sind die zumindest zwei Leuchtdiodenchips der Leuchtdiode in eine reflektierende Umhüllung eingebettet. Vorzugsweise sind sämtliche Leuchtdiodenchips der Leuchtdiode in die reflektierende Umhüllung eingebettet.

"Eingebettet" heißt dabei, dass die reflektierende Umhüllung die Leuchtdiodenchips zumindest stellenweise bedeckt und sich an den Orten der Bedeckung in direktem Kontakt mit den Leuchtdiodenchips befindet. Beispielsweise ist es möglich, dass die reflektierende Umhüllung bündig mit einer dem Träger abgewandten Strahlungsaustrittsfläche der Leuchtdiodenchips abschließt. Die zur Montagefläche quer verlaufenden Seitenflächen der Leuchtdiodenchips können dann beispielsweise vollständig von der reflektierenden Umhüllung bedeckt sein.

Darüber hinaus ist es auch möglich, dass die reflektierende Umhüllung die der Montagefläche abgewandte Strahlungsaustrittsfläche der Leuchtdiodenchips bedeckt. Die reflektierende Umhüllung weist dort dann eine derart geringe Dicke auf, dass im Betrieb in den Leuchtdiodenchips erzeugtes Licht durch die reflektierende Umhüllung nach außen treten kann. Die reflektierende Umhüllung wirkt an den Strahlungsaustrittsflächen der Leuchtdiodenchips dann als Streuschicht, welche das durchtretende Licht streut.

Die reflektierende Umhüllung bedeckt erfindungsgemäß neben den Leuchtdiodenchips auch zumindest Teile der Montagefläche. Beispielsweise ist die Montagefläche vollständig an freiliegenden Stellen, also insbesondere dort, wo kein Leuchtdiodenchip angeordnet ist, vollständig mit dem Material der reflektierenden Umhüllung bedeckt. Insbesondere ist es auch möglich, dass der gesamte Träger an seiner den Leuchtdiodenchips zugewandten Oberfläche von der reflektierenden Umhüllung bedeckt ist. Das heißt, sämtliche freiliegenden Bereiche des Trägers an dieser Oberfläche sind dann von der reflektierenden Umhüllung bedeckt.

Dabei ist es insbesondere möglich, dass die reflektierende Umhüllung einem Betrachter unter beispielsweise Beleuchtung mit Tageslicht weiß erscheint. Das heißt, die Leuchtdiode selbst kann bei geeigneter Bedeckung mit der reflektierenden Umhüllung, wenn also beispielsweise sämtliche freiliegenden Flächen des Trägers an der den Leuchtdiodenchips zugewandten Oberfläche mit der reflektierenden Umhüllung bedeckt sind, weiß erscheinen.

Die reflektierende Umhüllung ist dabei beispielsweise diffus reflektierend ausgebildet. Die reflektierende Umhüllung kann mit einem Matrixmaterial gebildet sein. Das Matrixmaterial kann beispielsweise ein Silikon enthalten oder aus einem Silikon bestehen. Ferner ist es möglich, dass es sich bei dem Matrixmaterial um eine Mischung aus einem Silikon mit einem Epoxid handelt, also um ein so genanntes Silikon-Epoxid-Hybridmaterial. In das Matrixmaterial der reflektierenden Umhüllung können reflektierende Partikel eingebracht sein. Die reflektierenden Partikel sind beispielsweise mit einem der folgenden Materialien gebildet, das heißt sie können aus einem der folgenden Materialien bestehen: TiO2, BaSO4, ZnO, AlxOy, ZrO2. Insbesondere strahlungsreflektierende Partikel, die mit ZrO2 gebildet sind, eignen sich besonders gut zur Reflexion von blauem Licht oder ultraviolettem Licht.

Insbesondere ist es auch möglich, dass die reflektierende Umhüllung im Matrixmaterial eine Mischung unterschiedlicher reflektierender Partikel, die mit unterschiedlichen der genannten Materialien gebildet sind, enthält. Auf diese Weise kann das Reflexionsspektrum der reflektierenden Umhüllung besonders gut an die Erfordernisse der Leuchtdiode angepasst werden.

Im Folgenden wird die hier beschriebene Leuchtdiode anhand von Ausführungsbeispielen und den dazugehörigen Figuren näher erläutert.

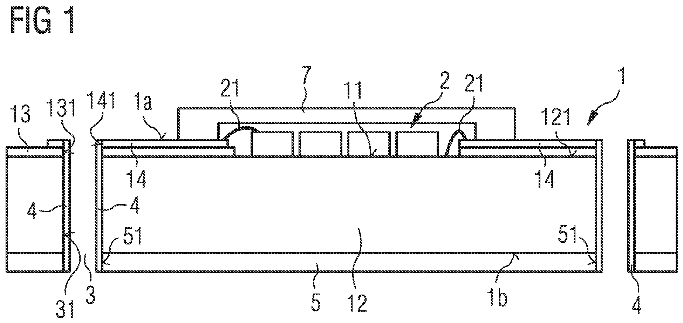

Die Figuren 1, 2, 3 und 4 zeigen Ausführungsbeispiele von hier beschriebenen Leuchtdioden anhand schematischer Schnittdarstellungen. Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1 zeigt eine schematische Schnittdarstellung eines ersten nicht erfindungsgemäßen Ausführungsbeispiels einer hier beschriebenen Leuchtdiode. Die Leuchtdiode umfasst einen Träger 1. Der Träger 1 umfasst einen metallischen Grundkörper 12, der den Hauptbestandteil des Trägers bildet. Vorliegend entfallen auf den metallischen Grundkörper 12 wenigstens 95 % des Volumens und des Gewichts des Trägers. Der metallische Grundkörper ist beispielsweise mit Kupfer gebildet, das heißt er enthält Kupfer oder er besteht aus Kupfer.

Der Träger 1 umfasst weiter eine weitere elektrisch isolierende Schicht 13, die stellenweise auf die Außenfläche 121 des metallischen Grundkörpers 12 an der Oberseite 1a des Trägers aufgebracht ist. Die weitere elektrisch isolierende Schicht 13 kann dabei in direktem Kontakt mit dem metallischen Grundkörper 12 stehen. Auf der dem metallischen Grundkörper 12 abgewandten Seite der weiteren elektrisch isolierenden Schicht 13 ist eine elektrisch leitende Schicht 14 aufgebracht, die beispielsweise zu Leiterbahnen strukturiert ist.

Der Träger 1 weist Öffnungen 3 auf, die den Träger, das heißt den metallischen Grundkörper 12, die weitere elektrisch isolierende Schicht 13 und die elektrisch leitende Schicht 14, vollständig von der Oberseite 1a des Trägers 1 zur Unterseite 1b des Trägers 1 durchdringen.

Innenflächen 31 jeder Öffnung 3 sind vorliegend vollständig vom elektrisch isolierenden Material 4 bedeckt. Das heißt, das elektrisch isolierende Material 4 bedeckt Seitenflächen des metallischen Grundkörpers 12, Seitenflächen 131 der weiteren elektrisch isolierenden Schicht und Seitenflächen 141 der elektrisch leitenden Schicht.

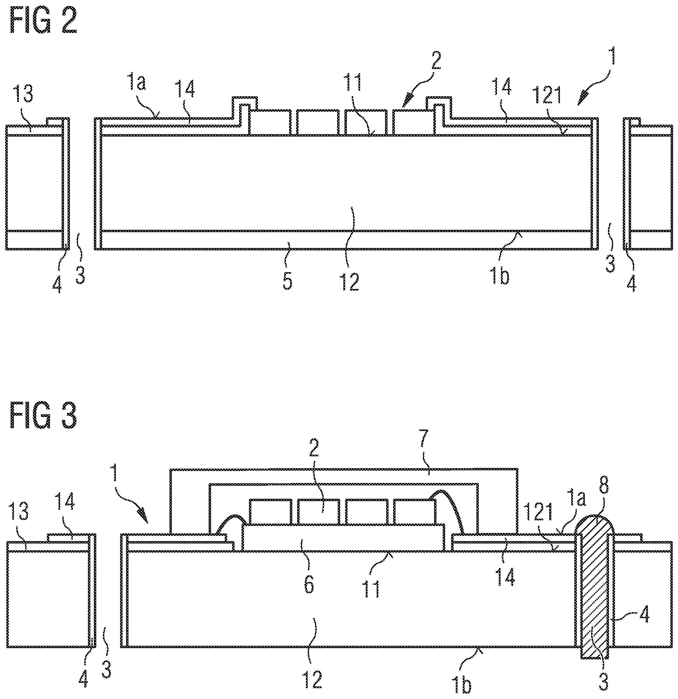

Jede Öffnung dient zur Aufnahme eines Befestigungsmittels 8, beispielsweise einer Schraube. Das Befestigungsmittel 8 ist dabei zur Montage der Leuchtdiode vorgesehen (vergleiche zum Befestigungsmittel 8 auch die Figur 3).

Im Ausführungsbeispiel der Figur 1 sind Leuchtdiodenchips 2 an der Montagefläche 11 des Trägers 1 direkt auf dem metallischen Grundkörper 12 aufgebracht, zum Beispiel aufgelötet. Die Leuchtdiodenchips 2 sind dabei parallel zueinander geschaltet und liegen an ihrer dem metallischen Grundkörper 12 zugewandten Seite auf demselben elektrischen Potenzial wie der metallische Grundkörper 12.

Die Leuchtdiodenchips 2 sind mittels Bonddrähten 21 elektrisch leitend mit der zu Leiterbahnen strukturierten elektrisch leitenden Schicht 14 verbunden. Dabei ist es möglich, dass einer der Bonddrähte 21 direkt mit dem metallischen Grundkörper 12 elektrisch leitend verbunden ist. Beispielsweise umfasst die Leuchtdiode vier Leuchtdiodenchips, die im Betrieb zur Erzeugung von blauem Licht und/oder UV-Strahlung vorgesehen sind. Jedem Leuchtdiodenchip 2 oder allen Leuchtdiodenchips 2 gemeinsam ist dann ein Lumineszenzkonversionsmaterial nachgeordnet, das zumindest einen Teil der von den Leuchtdiodenchips 2 im Betrieb erzeugten elektromagnetischen Strahlung derart konvertiert, dass insgesamt von der Leuchtdiode weißes Licht abgestrahlt wird.

Im Ausführungsbeispiel der Figur 1 ist sämtlichen Leuchtdiodenchips 2 eine Abdeckung 7 nachgeordnet, die mechanisch fest mit dem Träger 1 verbunden ist. Bei der Abdeckung 7 kann es sich beispielsweise um eine Abdeckung aus Glas handeln. Ferner ist es möglich, dass die Abdeckung 7 Partikel eines keramischen Lumineszenzkonversionsmaterial enthält oder aus einem keramischen Lumineszenzkonversionsmaterial besteht.

An der den Leuchtdiodenchips 2 abgewandten Unterseite des Trägers 1 ist vorzugsweise direkt auf den metallischen Grundkörper 12 die elektrisch isolierende Schicht 5 aufgebracht, welche den Träger 1 elektrisch isoliert. Seitenflächen 51 der elektrisch isolierenden Schicht können im Bereich der Öffnungen 3, welche die elektrisch isolierende Schicht 5 vollständig durchdringen, mit dem elektrisch isolierenden Material 4 bedeckt sein. Dabei ist es auch möglich, dass das elektrisch isolierende Material 4 und die elektrisch isolierende Schicht 5 mit dem gleichen Material gebildet sind.

In Verbindung mit der Figur 2 ist anhand einer schematischen Schnittdarstellung ein zweites nicht erfindungsgemäßes Ausführungsbeispiel einer hier beschriebenen Leuchtdiode näher erläutert. Im Unterschied zum Ausführungsbeispiel der Figur 1 findet die Kontaktierung der Leuchtdiodenchips 2 in diesem Ausführungsbeispiel über die zu Leiterbahnen strukturierte elektrisch leitende Schicht 14 statt. Die elektrisch leitende Schicht 14 ist dazu in direktem Kontakt mit nicht gezeigten Anschlussstellen der Leuchtdiodenchips 2. Im Ausführungsbeispiel der Figur 2 bedeckt die weitere elektrisch isolierende Schicht 13 dazu zumindest die Seitenflächen mancher Leuchtdiodenchips der Leuchtdiode stellenweise. Die elektrisch leitende Schicht 14 ist entlang der elektrisch isolierenden Schicht 13 an Seitenflächen dieser Leuchtdiodenchips 2 zu den elektrischen Anschlussstellen der Leuchtdiodenchips 2 geführt.

In Verbindung mit der Figur 3 ist ein drittes nicht erfindungsgemäßes Ausführungsbeispiel einer hier beschriebenen Leuchtdiode anhand einer schematischen Schnittdarstellung näher erläutert. In diesem Ausführungsbeispiel ist im Unterschied zu Figur 1 auf die elektrisch isolierende Schicht 5 verzichtet. Die Leuchtdiodenchips 2 sind über einen elektrisch isolierenden Zwischenträger 6, der zwischen dem metallischen Grundkörper 12 und den Leuchtdiodenchips 2 angeordnet ist, elektrisch vom metallischen Grundkörper 2 des Trägers 1 isoliert. Der Zwischenträger 6 besteht beispielsweise aus einem keramischen Material. An der dem metallischen Grundkörper 12 abgewandten Seite des Zwischenträgers 6 können metallische Leiterbahnen strukturiert sein, über die die Leuchtdiodenchips 2 auf dem Zwischenträger 6 parallel geschaltet sind. Die Leuchtdiode gemäß der Figur 3 zeichnet sich durch eine gemäß den Ausführungsbeispielen der Figur 1 und 2 vereinfachte Herstellung aus, da auf das Aufbringen der elektrisch isolierenden Schicht 5 verzichtet werden kann. Nachteilig ergibt sich, dass anders als in den in Verbindung mit den Figuren 1 und 2 erläuterten Ausführungsbeispielen keine unmittelbare Wärmespreizung von den Leuchtdiodenchips 2 in den metallischen Grundkörper 12 hinein erfolgt, sondern die Wärmeleitfähigkeit durch den Zwischenträger 6 herabgesetzt wird.

Die Abdeckung 7 kann in sämtlichen Ausführungsbeispielen vorhanden sein oder entfallen. Die Abdeckung 7 kann einen mechanischen Schutz der Leuchtdiodenchips 2 bilden und darüber hinaus optische Eigenschaften wie Strahlungskonvertierung und/oder Strahlungsstreuung übernehmen.

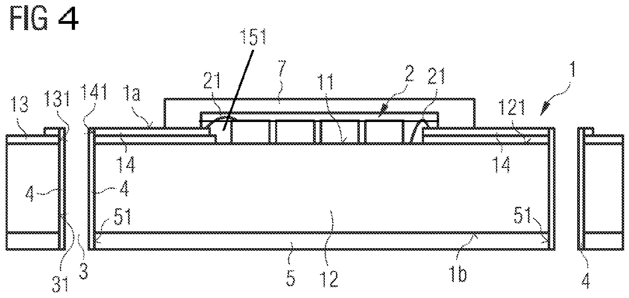

Anhand der schematischen Schnittdarstellung der Figur 4 ist ein erfindungsgemäßes Ausführungsbeispiel einer hier beschriebenen Leuchtdiode erläutert. Im Unterschied zu den vorgenannten nicht erfindungsgemäßen Ausführungsbeispielen umfasst die Leuchtdiode vorliegend eine reflektierende Umhüllung 151, in welche die Leuchtdiodenchips 2 eingebettet sind. Die reflektierende Umhüllung 151 bedeckt dabei die Montagefläche 11 des Trägers 1 vollständig. Die Leuchtdiodenchips 2 ragen in Ausführungsbeispiel der Figur 4 mit ihren dem Träger 1 abgewandten Oberflächen, welche die Strahlungsaustrittsflächen der Leuchtdiodenchips 2 darstellen, aus der reflektierenden Umhüllung 151 heraus. Beispielsweise schließt die reflektierende Umhüllung 151 bündig mit diesen Oberflächen ab. Die reflektierende Umhüllung ist dabei beispielsweise mit einem Matrixmaterial wie Silikon gebildet, in das strahlungsreflektierende Partikel, beispielsweise aus Titandioxid, eingebracht sind.

Eine reflektierende Umhüllung 151 kann dabei in sämtlichen Ausführungsbeispielen der hier beschriebenen Leuchtdiode zum Einsatz kommen. Beispielsweise beim Ausführungsbeispiel der Figur 3 würde die reflektierende Umhüllung 151 dann auch die freiliegende Außenfläche des Zwischenträgers 6 vollständig bedecken.

Die Erfindung ist nicht durch die Beschreibung anhand der Ausführungsbeispiele auf diese beschränkt.

## Patentansprüche

1. Leuchtdiode umfassend
- einen Träger (1) mit einer Montagefläche (11), und
- zumindest zwei Leuchtdiodenchips (2), die zumindest mittelbar an der Montagefläche (11) am Träger (1) befestigt sind,
wobei
- der Träger (1) einen metallischen Grundkörper (12) umfasst,
- eine Außenfläche (121) des metallischen Grundkörpers (12) die Montagefläche (11) umfasst, und
- die zumindest zwei Leuchtdiodenchips (2) elektrisch leitend mit dem metallischen Grundkörper (12) verbunden und über den metallischen Grundkörper (12) zueinander parallel geschaltet sind,
**dadurch gekennzeichnet, dass**
- die zumindest zwei Leuchtdiodenchips (2) in eine reflektierende Umhüllung (151) eingebettet sind,
- die reflektierende Umhüllung (151) die Montagefläche (11) und Seitenflächen der Leuchtdiodenchips bedeckt,
- die zumindest zwei Leuchtdiodenchips (2) mit ihren dem Träger (1) abgewandten Strahlungsaustrittsflächen aus der reflektierenden Umhüllung (151) herausragen, oder die reflektierende Umhüllung (151) mit den Strahlungsaustrittsflächen bündig abschließt, und
- an einer der Montagefläche (11) abgewandten Unterseite (1b) des Trägers (1) eine elektrisch isolierende Schicht (5) mit einer Wärmeleitfähigkeit von mindestens 2W/ (m·K) am Träger (1) befestigt ist.

2. Leuchtdiode gemäß Anspruch 1, bei der die Leuchtdiodenchips (2) direkt an der Montagefläche am Träger (1) befestigt sind, indem die Leuchtdiodenchips (2) direkt auf dem metallischen Grundkörper (12) des Trägers (1) angeordnet sind und mit diesem - abgesehen von einem Verbindungsmittel - in direktem Kontakt stehen.

3. Leuchtdiode gemäß einem der vorherigen Ansprüche,
bei der der metallische Grundkörper (12) einen Hauptbestandteil des Trägers (1) bildet und auf den metallischen Grundkörper (12) wenigstens 90 % des Volumens und wenigstens 90 % des Gewichts des Trägers (1) entfallen.

4. Leuchtdiode gemäß einem der vorherigen Ansprüche, bei der die elektrisch isolierende Schicht (5) eine Dicke von wenigstens 30 µm und höchstens 100 µm aufweist.

5. Leuchtdiode gemäß einem der vorherigen Ansprüche umfassend
- zumindest eine Öffnung (3) im Träger (1), die sich von einer Oberseite (1a) des Trägers (1) zu der der Oberseite (1a) abgewandten Unterseite (1b) des Träger (1) erstreckt, wobei
- die zumindest eine Öffnung (3) den Träger (1) vollständig durchdringt,
- die Innenfläche (31) der zumindest einen Öffnung (3) mit einem elektrisch isolierendem Material (4) bedeckt ist, und
- die zumindest eine Öffnung (3) zur Aufnahme eine Befestigungsmittels (8) zur Montage der Leuchtdiode vorgesehen ist.

6. Leuchtdiode gemäß dem vorherigen Anspruch,
bei der die zumindest eine Öffnung (3) den metallischen Grundkörper (12) vollständig durchdringt.

7. Leuchtdiode gemäß dem vorherigen Anspruch,
bei der
- die zumindest eine Öffnung (3) die elektrisch isolierende Schicht (5) vollständig durchdringt, und
- eine Seitenfläche (51) der elektrisch isolierenden Schicht (5) in der zumindest einen Öffnung (3) mit dem elektrisch isolierenden Material (4) bedeckt ist.

8. Leuchtdiode gemäß Anspruch 1,
bei der zwischen den Leuchtdiodenchips (2) und der Montagefläche (11) ein Zwischenträger (6) angeordnet ist, an dem die Leuchtdiodenchips (2) befestigt sind.

9. Leuchtdiode gemäß dem vorherigen Anspruch,
bei der der Zwischenträger (6) aus einem keramischen Material besteht.

10. Leuchtdiode gemäß einem der vorherigen Ansprüche,
bei der
- der Träger (1) eine weitere elektrisch isolierende Schicht (13) umfasst, die an der den Leuchtdiodenchips (2) zugewandten Seite am metallischen Grundkörper (12) befestigt ist, und
- der Träger (1) eine elektrisch leitende Schicht (14) umfasst, die an der dem metallischen Grundkörper (12) abgewandten Seite an der weiteren elektrisch isolierenden Schicht (13) befestigt ist, wobei
- die Leuchtdiodenchips (2) elektrisch leitend mit der elektrisch leitenden Schicht (14) verbunden sind.

11. Leuchtdiode gemäß dem vorherigen Anspruch,
bei der
- die zumindest eine Öffnung (3) die weitere elektrisch isolierende Schicht (13) und die elektrisch leitende Schicht (14) vollständig durchdringt, und
- eine Seitenfläche (131) der weiteren elektrisch isolierenden Schicht (3) in der zumindest einen Öffnung (3) und eine Seitenfläche (141) der elektrisch leitenden Schicht (14) in der zumindest einen Öffnung (3) mit dem elektrisch isolierenden Material (4) bedeckt sind.

12. Leuchtdiode gemäß einem der vorherigen Ansprüche,
bei der
- die elektrisch isolierende Schicht (5) eine keramische Schicht ist, und
- die elektrisch isolierende Schicht (5) eine Dicke von wenigstens 30 µm und höchstens 100 µm aufweist.

13. Leuchtdiode gemäß dem vorherigen Anspruch,
bei der
- die elektrisch isolierende Schicht (5) aus einem keramischen Material besteht.

14. Leuchtdiode gemäß einem der vorherigen Ansprüche,
bei der
- die elektrisch isolierende Schicht (5) Bornitrid enthält oder aus Bornitrid besteht.

15. Leuchtdiode gemäß einem der vorherigen Ansprüche,
bei der
- die reflektierende Umhüllung (151) unter Tageslicht weiß erscheint.

## Claims

1. Light-emitting diode comprising:
- a carrier (1) with a mounting face (11), and
- at least two light-emitting diode chips (2), which are affixed to the carrier (1) at least indirectly at the mounting face (11),
wherein
- the carrier (1) comprises a metallic basic body (12),
- an outer face (121) of the metallic basic body (12) comprises the mounting face (11), and
- the at least two light-emitting diode chips (2) are electrically conductively connected to the metallic basic body (12) and connected in parallel with one another via the metallic basic body (12),
**characterized in that**
- the at least two light-emitting diode chips (2) are embedded in a reflective coating (151),
- the reflective coating (151) covers the mounting face (11) and side faces of the light-emitting diode chips,
- the at least two light-emitting diode chips (2) protrude with their radiation exit surfaces which face away from the carrier (1) out of the reflective coating (151), or the reflective coating (151) terminates flush with the radiation exit surfaces, and
- an electrically insulating layer (5) with a thermal conductivity of at least 2W/(m·K) is affixed to the carrier (1) on a lower side (1b) of the carrier (1), said lower side facing away from the mounting face (11).

2. Light-emitting diode according to Claim 1,
in which the light-emitting diode chips (2) are affixed to the carrier (1) directly at the mounting face by virtue of the light-emitting diode chips (2) being arranged directly on the metallic basic body (12) of the carrier (1) and being in direct contact therewith - apart from a connecting means.

3. Light-emitting diode according to one of the preceding claims, in which the metallic basic body (12) forms a main part of the carrier (1) and the metallic basic body (12) accounts for at least 90% of the volume and at least 90% of the weight of the carrier (1).

4. Light-emitting diode according to one of the preceding claims, in which the electrically insulating layer (5) has a thickness of at least 30 µm and at most 100 µm.

5. Light-emitting diode according to one of the preceding claims, comprising:
- at least one opening (3) in the carrier (1), said opening extending from an upper side (1a) of the carrier (1) to the lower side (1b) of the carrier (1), said lower side facing away from the upper side (1a),
wherein
- the at least one opening (3) passes through the carrier (1) completely,
- the inner face (31) of the at least one opening (3) is covered by an electrically insulating material (4), and
- the at least one opening (3) is provided for accommodating a fixing means (8) for mounting the light-emitting diode.

6. Light-emitting diode according to the preceding claim, in which the at least one opening (3) passes through the metallic basic body (12) completely.

7. Light-emitting diode according to the preceding claim, in which
- the at least one opening (3) passes through the electrically insulating layer (5) completely, and
- a side face (51) of the electrically insulating layer (5) in the at least one opening (3) is covered by the electrically insulating material (4).

8. Light-emitting diode according to Claim 1,
in which an intermediate carrier (6), to which the light-emitting diode chips (2) are affixed, is arranged between the light-emitting diode chips (2) and the mounting face (11).

9. Light-emitting diode according to the preceding claim, in which the intermediate carrier (6) consists of a ceramic material.

10. Light-emitting diode according to one of the preceding claims, in which
- the carrier (1) comprises a further electrically insulating layer (13), which is affixed to the metallic basic body (12) on the side facing the light-emitting diode chips (2), and
- the carrier (1) comprises an electrically conductive layer (14), which is affixed to the further electrically insulating layer (13) on the side facing away from the metallic basic body (12), wherein
- the light-emitting diode chips (2) being electrically conductively connected to the electrically conductive layer (14).

11. Light-emitting diode according to the preceding claim, in which
- the at least one opening (3) passes through the further electrically insulating layer (13) and the electrically conductive layer (14) completely, and
- a side face (131) of the further electrically insulating layer (3) in the at least one opening (3) and a side face (141) of the electrically conductive layer (14) in the at least one opening (3) are covered by the electrically insulating material (4).

12. Light-emitting diode according to one of the preceding claims, in which
- the electrically insulating layer (5) is a ceramic layer, and
- the electrically insulating layer (5) has a thickness of at least 30 µm and at most 100 µm.

13. Light-emitting diode according to the preceding claim, in which the electrically insulating layer (5) consists of a ceramic material.

14. Light-emitting diode according to one of the preceding claims, in which the electrically insulating layer (5) contains boron nitride or consists of boron nitride.

15. Light-emitting diode according to one of the preceding claims, in which the reflective coating (151) appears white under daylight.

## Revendications

1. Diode électroluminescente comprenant:
- un support (1) avec une surface de montage (11); et
- tout au moins deux puces de diode électroluminescente (2) qui sont fixées tout au moins directement sur la surface de montage (11), au niveau du support (1);
dans lequel
- le support (1) comprend un corps de base (12) métallique,
- une surface externe (121) du corps de base (12) métallique comprend la surface de montage (11), et
- les tout au moins deux puces de diode électroluminescente (2) sont connectées de manière électriquement conductrice avec le corps de base (12) métallique et sont montées en parallèle, l'une vis-à-vis de l'autre, à travers le corps de base (12) métallique,
**caractérisée en ce que**:
- les tout au moins deux puces de diode électroluminescente (2) sont mises en place dans un gainage (151) réfléchissant;
- le gainage (151) réfléchissant recouvre la surface de montage (11) et les surfaces latérales des puces de diode électroluminescente;
- les tout au moins deux puces de diode électroluminescente (2) font saillie en dehors du gainage (151) réfléchissant avec leurs surfaces de sortie du rayonnement qui se trouvent à l'opposé du support (1), ou le gainage (151) réfléchissant vient se terminer dans un affleurement avec les surfaces de sortie du rayonnement; et
- une couche (5) électriquement isolante avec une conductivité thermique d'au moins 2W/(m·K) est fixée, au niveau du support (1), sur une face inférieure (1b) du support (1), laquelle se trouve à l'opposé de la surface de montage (11).

2. Diode électroluminescente selon la revendication 1, dans laquelle les puces de diode électroluminescente (2) sont fixées directement sur la surface de montage, au niveau du support (1), en ce sens que les puces de diode électroluminescente (2) sont disposées directement sur le corps de base (12) métallique du support (1) et se trouvent en contact direct avec celui-ci, à l'exception d'un moyen de jonction.

3. Diode électroluminescente selon l'une des revendications précédentes,
dans laquelle le corps de base (12) métallique forme un composant principal du support (1) et pour laquelle le corps de base (12) métallique représente tout au moins 90 % du volume et tout au moins 90 % du poids du support (1).

4. Diode électroluminescente selon l'une des revendications précédentes,
dans laquelle la couche (5) électriquement isolante présente une épaisseur de tout au moins 30 µm et de tout au plus 100 µm.

5. Diode électroluminescente selon l'une des revendications précédentes, comprenant:
- tout au moins une ouverture (3) dans le support (1), laquelle s'étend depuis une face supérieure (1a) du support (1) jusqu'à la face inférieure (1b) du support (1), laquelle se trouve à l'opposé de la face supérieure (la);
dans laquelle:
- la tout au moins une ouverture (3) traverse entièrement le support (1);
- la surface interne (31) de la tout au moins une ouverture (3) est recouverte avec une matière (4) électriquement isolante; et
- la tout au moins une ouverture (3) est prévue en vue de la réception d'un moyen de fixation (8) en vue du montage de la diode électroluminescente.

6. Diode électroluminescente selon la revendication précédente,
dans laquelle la tout au moins une ouverture (3) traverse entièrement le corps de base (12) métallique.

7. Diode électroluminescente selon la revendication précédente,
dans laquelle:
- la tout au moins une ouverture (3) traverse entièrement la couche (5) électriquement isolante; et
- une surface latérale (51) de la couche (5) électriquement isolante est recouverte avec la matière (4) électriquement isolante dans la tout au moins une ouverture (3).

8. Diode électroluminescente selon la revendication 1,
dans laquelle un support intermédiaire (6), auquel sont fixées les puces de diode électroluminescente (2), est disposé entre les puces de diode électroluminescente (2) et la surface de montage (11).

9. Diode électroluminescente selon la revendication précédente,
dans laquelle le support intermédiaire (6) est constitué à partir d'une matière céramique.

10. Diode électroluminescente selon l'une des revendications précédentes,
dans laquelle:
- le support (1) comprend une autre couche (13) électriquement isolante, laquelle est fixée, au niveau du corps de base (12) métallique, sur la face qui est orientée vers les puces de diode électroluminescente (2); et
- le support (1) comprend une couche (14) électriquement conductrice, laquelle est fixée sur la face qui se trouve à l'opposé du corps de base (12) métallique, au niveau de l'autre couche (13) électriquement isolante;
selon laquelle:
- les puces de diode électroluminescente (2) sont connectées de manière électriquement conductrice avec la couche (14) électriquement conductrice.

11. Diode électroluminescente selon la revendication précédente,
dans laquelle:
- la tout au moins une ouverture (3) traverse entièrement l'autre couche (13) électriquement isolante et la couche (14) électriquement conductrice; et
- une surface latérale (131) de l'autre couche (3) électriquement isolante est recouverte avec la matière (4) électriquement isolante dans la tout au moins une ouverture (3) et une surface latérale (141) de la couche (14) électriquement conductrice est recouverte avec la matière (4) électriquement isolante dans la tout au moins une ouverture (3).

12. Diode électroluminescente selon l'une des revendications précédentes,
dans laquelle:
- la couche (5) électriquement isolante est une couche céramique; et
- la couche (5) électriquement isolante présente une épaisseur de tout au moins 30 µm et de tout au plus 100 µm.

13. Diode électroluminescente selon la revendication précédente,
dans laquelle la couche (5) électriquement isolante est constituée à partir d'une matière céramique.

14. Diode électroluminescente selon l'une des revendications précédentes,
dans laquelle la couche (5) électriquement isolante contient du nitrure de bore ou est constituée à partir de nitrure de bore.

15. Diode électroluminescente selon l'une des revendications précédentes,
dans laquelle le gainage (151) réfléchissant présente un aspect blanc à la lumière du jour.
